(19) Europäisches Patentamt
European Patent Office
Office européen des brevets

(11) Veröffentlichungsnummer: **0 353 399 B1**

# (12) EUROPÄISCHE PATENTSCHRIFT

(45) Veröffentlichungstag der Patentschrift: **29.12.93**

(51) Int. Cl.$^5$: **H03L 7/197**, H03K 23/66

(21) Anmeldenummer: **89107903.0**

(22) Anmeldetag: **02.05.89**

## (54) Digital einstellbare Frequenzteilungsanordnung, insbesondere für Frequenzsynthesizer.

(30) Priorität: **30.07.88 DE 3826006**

(43) Veröffentlichungstag der Anmeldung:
**07.02.90 Patentblatt 90/06**

(45) Bekanntmachung des Hinweises auf die Patenterteilung:
**29.12.93 Patentblatt 93/52**

(84) Benannte Vertragsstaaten:
**FR GB NL**

(56) Entgegenhaltungen:
**EP-A- 0 125 790**
**EP-A- 0 202 347**
**WO-A-86/05046**
**FR-A- 2 431 800**

(73) Patentinhaber: **Wandel & Goltermann GmbH & Co. Elektronische Messtechnik**
**Postfach 12 62,**
**Mühleweg 5**
**D-72795 Eningen(DE)**

(72) Erfinder: **Rudolph, Georg Dipl.-Ing.**
**Albert-Schweizer-Weg 9**
**D-7412 Eningen u.A.(DE)**

(74) Vertreter: **Ott, Elmar, Dipl.-Ing.**
**Ott . Klocke . Neubauer**
**Patentanwälte,**
**Kappelstrasse 8**
**D-72160 Horb 1 (DE)**

EP 0 353 399 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3. 10/3.6/3. 3. 1)

## Beschreibung

Die Erfindung betrifft eine digital einstellbare Frequenzteilungsanornung gemäß dem Oberbegriff des Anspruch 1.

Derartige Frequenzteilungsanordnungen finden hauptsächlich in Frequenzsynthesizern zur Steuerung von in PLL-Schleifen liegenden Oszillatoren Anwendung.

Der Stand der Technik ist anhand der Figuren 1 bis 5 erläutert. Hierbei zeigt

Fig. 1 ein Blockschaltbild eines aus der DE-OS 35 44 371 bekannten Synthesizer mit fraktioneller Frequenzteilersteuerung;

Fig. 2 ein Blockschaltbild einer Frequenzteilersteuerung mit einem sogenannten Phasenakkumulator;

Fig. 3 eine Tabelle mit den bei einer normierten Frequenzeinstellinformation F = 9,1 in der Anordnung nach Figur 2 auftretenden Werten,

Fig. 4 ein Blockschaltbild einer Frequenzteilersteuerung mit einem aus einem Integrator, einem Differenzierer und einem Quantisierer bestehenden Phasenakkumulator und

Fig. 5 eine Tabelle mit den bei einer normierten Frequenzeinstellinformation F = 9,1 in der Anordnung nach Figur 4 auftretenden Werten.

Fig. 1 zeigt ein vereinfachtes Blockschaltbild eines Synthesizers mit einer gattungsgemäßen Frequenzteilungsanordnung. Ein spannungsgesteuerter Oszillator 1 (VCO) erzeugt ein gewünschtes Ausgangssignal. Er liegt zusammen mit einem Frequenzteiler 2, der nur auf ganzzahlige Frequenzteilungsfaktoren m einstellbar ist, einem mit einer Referenzfrequenz $f_{REF}$ beaufschlagten Phasenmesser 3 und einem Tiefpaß 4 mit Regler in einer phasengerasteten Frequenzregelschleife (PLL), die eine Steuerschaltung 5 enthält, deren Ausgang mit einem Steuereingang des Frequenzteilers 2 verbunden ist.

Die Frequenzteilerausgangsfrequenz $f_T$ wird vom Frequenzteiler 2 aus der vom VCO 1 gelieferten Frequenzteilereingangsfrequenz $f_0$ erzeugt und taktet die Steuerschaltung 5.

Der Mittelwert $\overline{f_T}$ der Frequenzteilerausgangsfrequenz $f_T$ wird im folgenden Abtastfrequenz $f_A$ genannt:

$$f_A = \overline{f_T}$$

Die Steuerschaltung 5 bestimmt für jeden Frequenzteilungszyklus einen eigenen ganzzahligen Frequenzteilungsfaktor m so und stellt den Frequenzteiler 2 entsprechend ein, daß die Folge der Frequenzteilungsfaktoren im zeitlichen Mittel gleich der an die Steuerschaltung 5 angelegten Frequenzeinstellinformation F ist.

Die Frequenzteilerausgangsfrequenz $f_T$ wird vom Phasenmesser 3 mit der Referenzfrequenz $f_{REF}$ verglichen. Die gemessene Abweichung wird über den Regler 4 in den VCO eingegeben, womit der Regelkreis geschlossen ist. Im eingeschwungenen Zustand ist die Abtastfrequenz $f_A$ gleich der Referenzfrequenz $f_{REF}$. Es gilt also:

$$f_{REF} = f_A = f_0/F = \overline{f_T}$$

Die der Steuerschaltung 5 eingebbare Frequenzinformation F stellt also die auf die Referenzfrequenz $f_{REF}$ normierte Frequenzteilereingangsfrequenz $f_0$ dar.

Aus DE-OS 35 44 371 und DE-OS 32 10 048 ist es jeweils bekannt, eine beliebig feine Frequenzauflösung trotz hoher Abtastfrequenz $f_A$ durch periodisches Verstellen des Frequenzteilungsfaktors um +1 oder um -1 zu bewirken, so daß der nur auf ganzzahlige Frequenzteilungsfaktoren m einstellbare Frequenzteiler 2 im zeitlichen Mittel eine gebrochene Frequenzteilung erzeugt. Die hierzu notwendige Berechnung der Frequenzteilungsfaktoren m wird bei der aus der DE-OS 35 44 371 bekannten Anordnung mittels eines sogenannten Phasenakkumulators und bei der aus DE-OS 22 40 216 bekannten Anordnung mit gleicher Wirkung mittels einer Synchronteilerkette durchgeführt. Bei Überlauf des Phasenakkumulators wird zum ganzen Anteil des Frequenzteilungsfaktors +1 oder -1 addiert. Bei der aus DE-AS 22 40 216 bekannten Anordnung wird die Modifikation des Frequenzteilungsfaktors um +1 (oder um -1) durch eine Impulsunterdrückungsschaltung (oder durch eine Impulseinfügungsschaltung) bewirkt, die bei jedem Überlauf der Synchronteilerkette einmal betätigt wird.

Ein Frequenzteiler mit periodischer Verstellung des Frequenzteilungsfaktors m um +1 oder um -1 wird auch "fraktioneller Frequenzteiler" genannt, und ein PLL, der einen solchen Frequenzteiler enthält, entsprechend "fraktioneller Synthesizer".

Fig.2 zeigt die bekannte Frequenzteilersteuerung mittels eines Phasenakkumulators für eine beliebige Frequenzauflösung. Die Frequenzeinstellinformation $F = f_0/f_A$ wird in einen Addierer 6 eingegeben. Die Summe wird in einem Quantisierer 7 in einen ganzen und einen gebrochenen Anteil zerlegt. Der im dick markierten Zweig erscheinende ganze Anteil bestimmt den momentanen Frequenzteilungsfaktor m, auf den der Frequenzteiler eingestellt wird. Der im nicht markierten Zweig erscheinende gebrochene Anteil wird in einem Verzögerer 8 auf einen zweiten Eingang des Addierers 6 gegeben und solange (im Takt der Frequenzteilerausgangsfrequenz $f_T$) mit dem gebrochenen Anteil der Frequeneinstellinformation F aufsummiert, bis er eine ganze Schwingung erreicht und damit einen um eins vergrösserten Frequenzteilungsfaktor m bewirkt und den Akkumulator verläßt.

Der gebrochene Anteil p(i) stellt die in der Frequenzteilerausgangsfrequenz $f_T$ von der gewünschten idealen Abtastfrequenz $f_A$ enthaltene Abweichung dar. Die Phase wird so korrigiert, daß sie wenigstens nie den Wert einer ganzen Schwingung überschreitet. Sie ist also, gemessen von Spitze zu Spitze, auf eine Schwingung beschränkt. Mit der normierten Zeit i

$i = 1, 2, 3 .... = tf_A, 2tf_A, 3tf_A, ....$

bestimmt sich die Wirkung der Frequenzteilersteuerung nach Fig. 2 durch die rekursive Gleichung

$F = f_0 / f_A$ (Normierung)
$p(i) = (p(i-1) + F) \bmod 1$ (Phasenakkumulation)
$m(i) = (p(i-1) + F) - ((p(i-1) + F) \bmod 1)$ (Teilerwert)

Der Verzögerer 8 besteht in nicht näher dargestellter Weise aus einer Anzahl D-Flip-Flops, die mit der Frequenzteilerausgangsfrequenz $f_T$ getaktet werden. Sie bewirken eine Verzögerung des angelegten digitalen Signals um eine Periode der Abtastfrequenz $f_A$ und stellen damit eine Laufzeit mit $1/f_A$ dar. Mit der Vereinbarung

$$z = e^{j2\ pi\ f/f_A}$$

lautet die Übertragungsfunktion des Verzögerers 8 als Fouriertransformierte bzw. z-Transformierte, wie es bei der Beschreibung digitaler Filter üblich ist,

$$z^{-1} = e^{-j2\ pi\ f/f_A},$$

was in das Blockschaltbild des Verzögerers 8 zur Kennzeichnung eingetragen ist.

Die in Figur 3 dargestellte Tabelle enthält die in aufeinanderfolgenden Abtastperioden $1/f_A$ auftretenden Signalwerte, an Hand derer das Funktionieren der fraktionellen Steuerung der in Fig. 2 dargestellten Anordnung ersichtlich ist. Bei diesem und bei allen folgenden Beispielen ist der Inhalt des Phasenakkumulators beim Start Null, und es gelten folgende Annahmen:

$f_0 = 9{,}1$ MHz; $\overline{f_T} = f_A = 1$ MHz; $F = 9{,}1$

Fig. 4 zeigt eine etwas andere Darstellung eines Phasenakkumulators. Diese lehnt sich ebenfalls an die bei digitalen Filtern übliche Darstellungsweise an. Die Wirkung ist dieselbe wie die des Phasenakkumulators nach Fig.2 und Fig.3. Die Frequenzeinstellinformation F wird in einem Integrator 9 mit der Übertragungsfunktion I(z) in eine normierte Phase phi umgerechnet. Ein Quantisierer 10 spaltet den ganzzahligen Anteil dieser Phase, also ganze Schwingungen, ab. Der ganzzahlige Anteil wird in einem Differenzierer 11 mit der Übertragungsfunktion D(z) wieder in eine normierte Frequenz umgerechnet und ergibt eine Folge von Frequenzteilungsfaktoren m = m(i), die direkt in den Frequenzteiler eingegeben wird. Beim Differenzieren bleiben die Werte ganzzahlig. Die Frequenzeinstellinformation F stellt den (normierten) Phasenzuwachs pro Abtastperiode $1/f_A$ dar. Die Rechentaktfrequenz für den Integrator und für den Differenzierer entspricht in ihrer Wirkung der Abtastfrequenz $f_A$.

Der Integrator 9 besteht aus einem Verzögerer 12 und einem Addierer 13, der das Eingangssignal auf das um einen Rechentakt verzögerte Ausgangssignal summiert. Die Verzögerungstaktfrequenz ist die Frequenzteilerausgangsfrequenz $f_T$, die in der Wirkung der Abtastfrequenz $f_A$ entspricht. Mit der Übertragungsfunktion $z^{-1}$ des Verzögerers 12 erhält man die Übertragungsfunktion des Integrators zu

$$I(z) = \frac{1}{1 - z^{-1}},$$

die einen Pol der Übertragungsfunktion bei z = 1 besitzt (gleichbedeutend mit Polen bei $f = kf_A$, mit k = 0, 1, ..). Man erhält diese Übertragungsfunktion, indem man die Gleichung am Summierer

$$\begin{aligned} y(i) &= x(i) + y(i-1) \\ &= x(i) + z^{-1}\, y(i) \end{aligned}$$

mit dem Eingangssignal x(i) und dem Ausgangssignal y(i) aufstellt und den Quotienten y(i) / 1 x(i) berechnet.

Der Differenzierer 11 mit der Übertragungsfunktion D(z) besteht aus einem Verzögerer 15 und einem Addierer 14, der sein Eingangssignal auf das Negative seines um einen Rechentakt verzögerten Eingangssignals summiert und ausgibt. Die Übertragungsfunktion ergibt sich sinngemäß zu

$D(z) = 1 - z^{-1}$

die eine Nullstelle bei z = 1 besitzt. Die Übertragungsfunktion des Differenzierers ist invers zu der des Integrators.

Dieses sogenannte digitale Filter zur Steuerung eines fraktionellen Frequenzteilers nach Fig.4 kann durch folgenden Gleichungssatz beschrieben werden

$F = f_0/f_A$ (Normierung)
phi(i) = phi(i-1) + F (Integration)
q(i) = phi(i) - (phi(i)mod 1) (Quantisierung)
d(i) = q(i) - q(i-1) (Differentiation)
m(i) = d(i) (Teilerwert),

woraus sich die Tabelle gemäß Figur 5 errechnet. Auch hier ist phi zu Beginn Null.

Es kann bei der praktischen Realisierung einer Frequenzteilersteuerung nach Fig. 4 ein Nachteil sein, daß die Addierer und die Verzögerer eine ausreichend große Wortbreite besitzen müssen, da das Integral der positiven Frequenz monoton ansteigt.

Bei vielen Anwendungen sind die durch das oben beschriebene fraktionelle Prinzip erzeugten Phasenschwankungen nicht akzeptabel. Besonders störend ist der Fall, wenn der gebrochene Anteil der Frequenzinformation sehr klein ist, d.h., verhältnismäßig nahe an einer ganzzahligen Frequenzteilungseinstellung liegt, da hierbei der größte Teil der Störungen so tieffrequent ist, daß ein Filter oder eine PLL die Störungen kaum unterdrücken kann und somit diese Störungen ungemindert im Ausgangssignal des Frequenzteilers bzw. des VCO enthalten sind. Weniger kritische Fälle, wenn die fraktionelle Phasenstörungen in $f_T$ verhältnismäßig weit von $f_A$ entfernt liegen, werden hier nicht weiter betrachtet.

Es sind verschiedene elektronische Schaltungen bekannt, die diese Phasenstörungen vermindern.

Aus der DE-AS 22 40 216 ist es bekannt, die Phaseninformation im Phasenakkumulator über einen D/A-Wandler in eine Kompensationsspannung umzuwandeln, die die am Ausgang des Phasenmessers auftretende Störspannung durch eine entsprechende vorzeichenrichtige Addition aufhebt (kompensiert).

Aus der DE-OS 32 10 048 ist es bekannt, die mit Phasenstörungen behafteten Ausgangsimpulse eines fraktionellen Frequenzteilers vor dem Phasenmesser mit Hilfe eines gesteuerten Laufzeitgliedes in geeigneter Weise zu verzögern und damit äquidistant zu machen:
Für jede Abtastfrequenzperiode wird über die Spannung des D/A-Wandlers ein Verzögerungsglied so eingestellt, daß die vom VCO Kommenden Impulse am Phasenmesser gleichförmig ankommen. Die notwendige Verzögerung ist proportional zum Inhalt des Phasenakkumulators. Das einstellbare Verzögerungsglied kann vor oder nach dem programmierbaren Teiler eingefügt sein.

Bei beiden bekannten Anordnungen wird der Phasenfehler mit analogen Mitteln kompensiert. Die Güte der Kompensation wird deshalb von der Linearität und den Steilheitsschwankungen der wirksamen Baugruppen begrenzt.

Aus EP-A-0 125 790 ist weiter eine Anordnung bekannt, bei der mehrere Integrierer und Differenzierer für die Ermittlung des momentanen Teilungs verhältnisses zusammenwirken.

Der Erfindung liegt die Aufgabe zugrunde, eine fraktionelle Frequenzteilungsanordnungmit einem nur auf ganze Frequenzteilungsfaktoren einstellbaren Frequenzteiler so zu verbessern, daß sie trotz der fraktionellen Frequenzteilung mit hoher Frequenzauflösung im Frequenzteilerausgangssignal $f_T$ dicht bei der Abtastfrequenz $f_A$ wenig Phasenstörungen aufweist.

Diese Aufgabe wird bei einer gattungsgemäßen Einrichtung durch die gekennzeichneten Merkmale des Anspruchs 1 gelöst.

Auf diese Weise müssen dann nur noch die Spektralanteile, die von der Abtastfrequenz fA weiter entfernt liegen, mit einem Filter oder über die Trägheit einer PLL bedämpft werden.

Die Erfindung nützt die Tatsache aus, daß jeder mittlere (gebrochene) Frequenzteilungsfaktor durch sehr viele unterschiedliche-Folgen von ganzzahligen Frequenzteilungsfaktoren m realisiert sein kann. Dieser Freiheitsgrad kann in verschiedenem Ausmaß dazu benutzt werden, irgend eine solche Folge zu erzeugen und zu verwenden, deren unmittelbar in die Nachbarschaft von $f_A$ fallender Spektralanteil möglichst gering ist.

Selbst ein zu einer keinen gebrochenen Anteil besitzenden Frequenzeinstellinformationvon beispielsweise F = 10,0 gehöriger ganzzahliger mittlerer Frequenzteilungsfaktor von m = 10,0 kann außer durch eine Folge gleicher ganzzahliger Frequenzteilungsfaktoren 10, 10, usw.noch durch eine Vielzahl anderer Folgen erzeugt werden, beispielsweise durch eine Folge 9, 11 ,9, 11 usw. oder auch durch eine Folge 8, 12, 8, 12 usw. oder auch durch eine Folge 10, 10, 9, 10, 10, 11, 10, 10, 9, 10, 10, 11 usw. oder durch noch andere solcher Folgen mit dem Mittelwert 10. Praktisch ergeben sich unendlich viele Möglichkeiten. Entsprechendes gilt für gebrochene Frequenzinformationen F. Ein Filter oder eine PLL kann auf solche Weise entstehenden flinken Teilungsschwankungen nur bedingt folgen. Der durch solche Teilungsumschaltungen hervorgerufene Phasenfehler, der gleich der Aussteuerung am Ausgang des Phasenmessers ist, nimmt zwar gegenüber dem Phasenfehler zu, wie er bei den bekannten Anordnungen mit einfacher fraktioneller Steuerung eines Frequenzteilers auftritt. Doch kann mit zunehmender Aussteuerung das Spektrum günstiger verteilt werden, so daß mit zunehmender Aussteuerung in unmittelbarer Nachbarschaft der Spektrallinie $f_A$ zunehmend schwache Spektralanteile vorhanden sind. Anschließende Spektralbereiche können durch ein nachgeschaltetes Filter, z,B. durch ein PLL-Schleifenfilter, leicht verringert werden. Ob ein Gewinn durch eine Folge von Frequenzteilungsfaktoren mit größerer Variation erzielt werden kann, hängt von der für $f_T$ möglichen Filterung ab.

Im fraktionellen Synthesizer ist für die resultierenden Phasenstörungen im Ausgangssignal des VCO bei den verschiedenen Folgen von Frequenzteilungsfaktoren mit höherer Aussteuerung insbesondere der genaue Verlauf der Führungsübertragungsfunktion im Dämpfungsbereich ausschlaggebend.

Zwei Ausführungsbeispiele der Erfindung sind in der Zeichnung dargestellt und werden im folgenden näher beschrieben. Es zeigen

- Fig. 6 ein Blockschaltbild eines ersten Ausführungsbeispiels mit einer Frequenzteilersteuerung mit n = 2 Integratoren,
- Fig. 7 eine Tabelle mit den in der Anordnung gemäß Figur 6 auf tretenden Signalwerten für das Beispiel F = 9,1;
- Fig. 8 ein Blockschaltbild eines zweiten Ausführungsbeispiels mit einer Frequenzteilersteuerung mit Kürzung der ganzzahligen Integrationen mit den Differentiationen und
- Fig. 9 eine Tabelle mit den in der Anordnung gemäß Figur 8 auftretenden Signalwerten für das Beispiel F = 9,1.

Figur 6 zeigt den Steuerungsteil einer Frequenzteilungsanordnung zur Berechnung der Frequenzteilungsfaktoren m mit Hilfe eines Phasenakkumulators, zweier Integratoren, eines Quantisierers auf ganze Schwingungen und dreier Differenzierer (n = 2).

Die fraktionelle Phase p(i), die der Phasenakkumulator 6, 7 und 8 berechnet, wird in den beiden Integratoren 16 und 17 integriert und im Quantisierer 18 auf den ganzen Wert q(i) abgeschnitten. Dieser wird über die Differenzierer 19, 20 und 21 dreifach differenziert, und er ergibt zusammen mit dem ganzen Anteil des Phasenakkumulators $m_o(i)$ die Folge von Frequenzteilungsfaktoren m = m(i).

Hierfür gilt der Satz von Gleichungen:

$F = f_O/f_A$ (Normierung)

$p(i) = (p(i-1) + F) \bmod 1$ (Phasenakkumulation)

$s_1(i) = s_1(i-1) + p(i)$ (1. Integration)

$s_2(i) = s_2(i-1) + s_1(i)$ (2. Integration)

$q(i) = s_2(i) - (s_2(i) \bmod 1)$ (Quantisierung)

$d_1(i) = q(i) - q(i-1)$ (1. Differentiation)
$d_2(i) = d_1(i) - d_1(i-1)$ (2. Differentiation)
$d_3(i) = d_2(i) - d_2(i-1)$ (3. Differentiation)
$m(i) = (p(i-1)+F)-((p(i-1)+F) \bmod 1)+d_3(i)$ (Teilerwert)

Die in Figur 7 dargestellte Tabelle zeigt die sich beim Betrieb der in Figur 6 dargestelleten Anordnung bei F = 9,1 ergebenden Wertefolgen. Die letzte Zahlenkolonne "Phasenfehler" zeigt den im Frequenzteilerausgangssignal enthaltenen absoluten Phasenfehler. Man erhält ihn, indem man den gebrochenen Anteil r(i), der am Quantisierer abgespalten wird, zweimal differenziert, denn nach der Phasenakkumulation erhält man nach zwei Integrationen und zwei Differentiationen wieder einen Phasenwert. Bei diesem Beispiel ist der Absolutfehler der Phase auf 1,1 - (-1,2) = 2,3 Teilereingangsperioden angestiegen.

Eine vorteilhafte Weiterbildung der Erfindung ergibt sich mit den kennzeichnenen Merkmalen des Anspruchs 2. Eine gegebene endliche Rechengenauigkeit in den Nachkommastellen einer Integration verursacht umso weniger Störungen in $f_T$, je höher das zu berechnende Integral ist. Z.B. kann $s_2(i)$ weniger Nachkommastellen als $s_1(i)$ besitzen, da allgemein ein Rundungsrauschen in $s_r(i)$, wenn man es r mal differenziert, die (normierte) Störphase in $f_T$ ergibt. Jede dieser Differentiationen besitzt in der Umgebung von $f = kf_A$ Dämpfung (k = 0, 1, 2, ...). Eine solche Rundung kann eine andere Folge von Frequenzteilungsfaktoren m bewirken.

Eine weitere Ausführungsform der Erfindung ergibt sich mit den kennzeichnenen Merkmalen des Anspruchs 3. Eine Vorverzerrung der Frequenzteilungsfaktoren m kann auch durch ein steuerndes Filter erreicht werden, das nicht nur Pole und Nullstellen bei z = 1 besitzt. Mit gleichem Erfolg könnte als Integrator und Differenzierer zum Beispiel

$$I^*(z) = \frac{1}{1 - z^{-v}} = \frac{1}{D^*(z)} \quad ; \qquad (v = E\{1, 2, \ldots\})$$

mit der Rekursionsgleichung des Integrators von

$$\begin{aligned} y^*(i) &= x^*(i) + y^*(i-v) \\ &= x^*(i) + z^{-v} \cdot y^*(i) \end{aligned}$$

verwendet werden. Diese Filter haben v Pole bzw. Nullstellen auf dem Einheitskreis $|z| = 1$. Sie ergeben eine andere Folge von Frequenzteilungsfaktoren m. Dabei ist der Spitze-Spitze-Wert der Phasenstörungen allerdings größer als der bei der Anordnung gemäß Figur 6 auftretende Wert.

Es sei darauf hingewiesen, daß die Integratoren am Ausgang fortlaufend immer größere Signalwerte annehmen. Diese Signalwerte treten aber nur intern auf. In der Praxis wird man entweder die Integratoren nach einer gewissen Zeit zurücksetzen, was eine kurzzeitige Unterbrechung der Schaltungsfunktion bedeutet, oder man zieht die Integratoren und Differenzierer für den ganzzahligen Teil zusammen. Dies entspricht einer Kürzung, so daß keine immer größer werdende Signalwerte auftreten, wie sich dies an sich beim Gegenstand des Anspruchs 1 ergibt.

Weiter ist es auch möglich, die zur Erzeugung einer gewünschten Frequenz erforderliche Folge der Frequenzteilungsfaktoren einmal zu berechnen, sie in einem Speicher abzulegen und sie anschließend aus dem Speicher periodisch auszulesen, ohne sie ständig in Echtzeit mit einem digitalen Filter zu berechnen.

Fig. 8 zeigt eine Weiterbildung der Erfindung mit Kürzung des ganzzahligen Anteils der Integrale mit den nachfolgenden Differentiationen, die aus der in Figur 6 dargestellten Anordnung durch Ersatz von deren Integrator 17, Quantisierer 18 und Differenzierer 19 (alle in Figur 6) durch den Akkumulator 26, 27 und 28, wodurch nur noch zwei Differenzierer 29 bis 32 benötigt werden, und Ersatz des Integrators 16 in Figur 6 durch den Akkumulator 23 bis 25, dessen ganzer Anteil sinngemäß am Addierer 29 eingespeist wird. Die Addierer 29 und 31 haben jeweils drei Eingänge, von denen einer ein negatives Vorzeichen trägt ,um zusammen mit den Verzögerern 30 und 32 die differenzierende Funktion zu bilden.

An den Addierern und Verzögerern der Anordnung gemäß Figur 8 treten ausschließlich amplitudenbeschränkte Signalwerte auf, weshalb sie sich für eine Echtzeitberechnung gut eignet.

Die in Figur 9 dargestellte Tabelle zeigt die sich beim Betrieb der in Figur 8 dargestellten Anordnung bei F = 9,1 ergebenden Wertefolgen. Aus einem Vergleich der Tabellenwerte der Figuren 7 und 9 geht hervor, daß die Wirkung der in den Figuren 6 und 8 dargestellten Anordnung diesselbe ist. Das in der Anordnung gemäß Figur 8 auftretende Signal $p_2(i)$ ist gleich dem in der Anordnung gemäß Figur 6 auftretenden Signal r(i), woraus nach doppelter Differentiation wiederum derselbe Phasenfehler resultiert.

Zur weiteren Verringerung von Phasenstörungen können auch bekannte analoge Kompensationsmittel eingesetzt werden.

## Patentansprüche

1. Frequenzteilungsanordnung zum Erzeugen einer Frequenz $f_T$ aus einer gegebenen Frequenz $f_O$ mit einem nur auf ganzzahlige Frequenzteilungsfaktoren m einstellbaren Frequenzteiler (2), der im Mittel ein ganzes oder gebrochenes Frequenzteilungsverhältnis durch laufendes Neueinstellen von m verwirklicht, das einer Frequenzeinstellinformation F entspricht, und bei der eine Steuerschaltung (5) vorgesehen ist, die einen mit dem gebrochenen Anteil der Frequenzeinstellinformation F beaufschlagten Phasenakkumulator (6,7,8) enthält, die vom Teilerausgangssignal $f_T$ oder einem hierzu synchronen Signal getaktet wird und die für jeden Frequenzteilungszyklus einen neuen Wert m liefert, wobei die Folge von Frequenzteilungsfaktoren m entweder in Echtzeit berechnet oder aus einem Speicher ausgelesen wird, wenn sie periodisch ist, wobei die Glieder der Folge jeweils aus zwei Anteilen bestehen, von denen ein erster Anteil ($m_o(i)$) aus der Summe des ganzen Teils der Frequenzeinstellinformation F und einem Übertrag des Phasenakkumulators besteht und von denen ein zweiter Anteil ($d_3$-(i)) aus dem Inhalt des Phasenakkumulators berechnet ist, **dadurch gekennzeichnet**, daß der zweite Anteil zwecks Verminderung der in die Umgebung des Mittels von $f_T$ fallenden Spektralanteile der Phasenstörungen unter Inkaufnahme einer Zunahme der weiter abliegenden Spektralanteile und eines Anstiegs des Absolutwerts der Phasenstörungen auf grösser als 2(n-1) Perioden $1/f_0$, gemessen über Spitze-Spitze, wie folgt berechnet wird:
Der Inhalt des Phasenakkumulators (p(i)) wird n mal, n = 2, 3, ... , in digitalen Integratoren (16,17) mit dem Eingang x und mit dem Ausgang y, die durch die Rekursionsformel y(i) = y(i-1) + x(i) definiert sind, integriert;
das Ergebnis wird auf einen ganzen Wert abgeschnitten (18);
der ganze Wert wird n+1 mal in digitalen Differenzierern (19,20,21) mit dem Eingang x und mit dem Ausgang y, die durch die Formel

$$y(i) = x(i) - x(i-1)$$

definiert sind, differenziert,
wobei die Integratoren, die Differenzierer und der Phasenakkumulator denselben Rechentakt ($f_T$) haben.

2. Anordnung nach Anspruch 1, **dadurch gekennzeichnet**, daß die Integrale mit reduzierter Wortlänge (Auflösung) in ihrem gebrochenen Teil berechnet werden.

3. Anordnung nach Anspruch 1 oder 2, **dadurch gekennzeichnet**, daß anstelle der zwei oder mehr Integratoren andere Filterfunktionen mit wenigstens zwei Polen der Übertragungsfunktion bei f = 0 bzw. z = 1 und anstelle der drei oder mehr Differenzierer andere Filterfunktionen mit ganzen Koeffizienten und wenigstens zwei Nullstellen der Übertragungsfunktion bei f = 0 bzw. z = 1 verwendet werden.

4. Anordnung nach einem der Ansprüche 1 bis 3, **dadurch gekennzeichnet**, daß die niederwertigeren Stellen des gebrochenen Anteils der Integrale mit reduzierter Taktfrequenz berechnet werden.

5. Anordnung nach einem der Ansprüche 1 bis 4, **gekennzeichnet durch** ihre Anwendung als einstellbarer Frequenzteiler in der Phasenregelschleife eines Frequenzsynthesizers.

6. Anordnung nach einem der Ansprüche 1 bis 4, **gekennzeichnet durch** ihre Anwendung bei der Erzeugung einer Frequenz durch Teilen der Frequenz f0 und anschließendes Bandfiltersieben der geteilten Frequenz $f_T$.

7. Anordnung nach einem der Ansprüche 1 bis 4, **dadurch gekennzeichnet**, daß die Integrationen für große ganze Werte mit den Differentiationen gekürzt werden.

## Claims

**1.** Frequency dividing arrangement for generating a frequency $f_T$ from a given frequency $f_0$, which comprises a frequency divider (2) that can be adjusted only to integer frequency dividing factors m and that produces, by continuous re-setting of m, as a mean a whole or fractional frequency dividing ratio corresponding to a frequency adjusting value F, and in which a control circuit (5) is provided that contains a phase accumulator (6, 7, 8) acted upon by the fractional portion of the frequency adjusting value F, is timed by the divider output signal $f_T$ or by a signal synchronous therewith and provides a new value m for every frequency dividing cycle, the sequence of frequency dividing factors m either being calculated in real time or being read out of a memory if it is periodic, the members of the sequence each consisting of two portions of which a first portion ($m_o(i)$) consists of the sum of the integer part of the frequency adjusting value F and a carry of the phase accumulator and a second portion ($d_3(i)$) is calculated from the contents of the phase accumulator, characterised in that, in order to reduce the spectral portions of the phase interference that fall into the vicinity of the mean of $f_T$ while tolerating an increase in the spectral portions lying further away and a rise in the absolute value of the phase interference to greater than 2(n-1) periods l/$f_0$, measured peak-to-peak, the second portion is calculated as follows:
the contents of the phase accumulator (p(i)) are integrated n times, n = 2, 3, ..., in digital integrators (16, 17) having the input x and the output y defined by the recursion formula $y(i) = y(i-1) + x(i)$;
the result is truncated (18) to an integer value;
the integer value is differentiated n+1 times in digital differentiators (19, 20, 21) having the input x and the output y defined by the formula

$$y(i) = x(i) - x(i-1),$$

the integrators, the differentiators and the phase accumulator having the same calculation clock period ($f_T$).

**2.** Arrangement according to claim 1, characterised in that the integrals having a reduced word length (resolution) are calculated in their fractional part.

**3.** Arrangement according to claim 1 or 2, characterised in that, instead of the two or more integrators, other filter functions having at least two poles of the transfer function at f = 0, or z = 1, are used and, instead of the three or more differentiators, other filter functions having integer coefficients and at least two zeros of the transfer function at f = 0, or z = 1, are used.

**4.** Arrangement according to any one of claims 1 to 3, characterised in that the lower value points of the fractional portion of the integrals are calculated at reduced clock frequency.

**5.** Arrangement according to any one of claims 1 to 4, characterised by its use as an adjustable frequency divider in the phase regulating loop of a frequency synthesizer.

**6.** Arrangement according to any one of claims 1 to 4, characterised by its use in generating a frequency by dividing the frequency $f_0$ and subsequently band-filtering the divided frequency $f_T$.

**7.** Arrangement according to any one of claims 1 to 4, characterised in that the integrations for large integer values are cancelled by the differentiations.

## Revendications

**1.** Dispositif de division de fréquence pour engendrer une fréquence $f_T$ à partir d'une fréquence donnée $f_0$, présentant un diviseur de fréquence (2) pouvant être réglé uniquement sur des facteurs m de division de fréquence représentant des nombres entiers, ce diviseur provoquant en moyenne un rapport entier ou fractionné de division de fréquence par nouveau réglage permanent de m, qui correspond à une information F de réglage de fréquence, dispositif dans lequel est prévu un circuit de commande (5) qui renferme un accumulateur de phases (6, 7, 8) sollicité par la part fractionnée de l'information F de réglage de fréquence, qui est rythmé par le signal de sortie $f_T$ du diviseur ou par un signal synchrone de ce dernier, et qui délivre une nouvelle valeur m pour chaque cycle de division de fréquence, la succession de facteurs m de division de fréquence étant soit calculée en temps réel, soit lue à partir d'une mémoire lorsqu'elle est périodique, les termes de la succession comprenant respectivement deux fractions dont une première fraction [$m_o(i)$] est constituée par la somme de la part entière de l'information F de réglage de fréquence et d'un report de l'accumulateur de phases, et dont une seconde fraction [$d_3(i)$] est calculée sur la base du contenu de l'accumulateur de phases, dispositif caractérisé par le fait que la seconde fraction est calculée, en vue d'une diminution des fractions spectrales des perturbations de phases avoisinant la moyenne de $f_T$, en tenant compte d'une augmentation des fractions spectrales ultérieures et d'un accroissement de la valeur absolue des perturbations de phases jusqu'à excéder 2(n-1) périodes $1/f_0$, avec mesure de crête à crête, de la façon suivante :
le contenu [p(i)] de l'accumulateur de phases est intégré n fois, n = 2, 3, ..., dans des intégrateurs numériques (16, 17), avec l'entrée x et avec la sortie y qui sont définies par la formule de récurrence y(i) = y(i-1) + x(i) ;
le résultat est écrêté (18) jusqu'à une valeur entière ;
la valeur entière est différenciée n+1 fois dans des différenciateurs numériques (19, 20, 21), avec l'entrée x et avec la sortie y qui sont définies par la formule

$$y(i) = x(i) - x(i-1),$$

les intégrateurs, les différenciateurs et l'accumulateur de phases présentant le même rythme de calcul ($f_T$).

2. Dispositif selon la revendication 1, caractérisé par le fait que les intégrales à longueur de mot réduite (résolution) sont calculées pour leur part fractionnée.

3. Dispositif selon la revendication 1 ou 2, caractérisé par le fait qu'on utilise, à la place des deux intégrateurs ou plus, d'autres fonctions de filtrage avec au moins deux pôles de la fonction de transmission pour f = 0, respectivement z = 1, et qu'on utilise, à la place des trois différenciateurs ou plus, d'autres fonctions de filtrage avec des coefficients entiers et avec au moins deux remises à zéro de la fonction de transmission pour f = 0, respectivement z = 1.

4. Dispositif selon l'une des revendications 1 à 3, caractérisé par le fait que les zones à valeur moindre de la part fractionnée des intégrales sont calculées avec fréquence de rythme réduite.

5. Dispositif selon l'une des revendications 1 à 4, caractérisé par son utilisation en tant que diviseur réglable de fréquence dans la boucle de réglage de phases d'un synthétiseur de fréquence.

6. Dispositif selon l'une des revendications 1 à 4, caractérisé par son utilisation pour la génération d'une fréquence par division de la fréquence $f_0$, et par filtrage passe-bande consécutif de la fréquence divisée $f_T$.

7. Dispositif selon l'une des revendications 1 à 4, caractérisé par le fait que les intégrations pour de grandes valeurs entières sont raccourcies avec les différenciations.

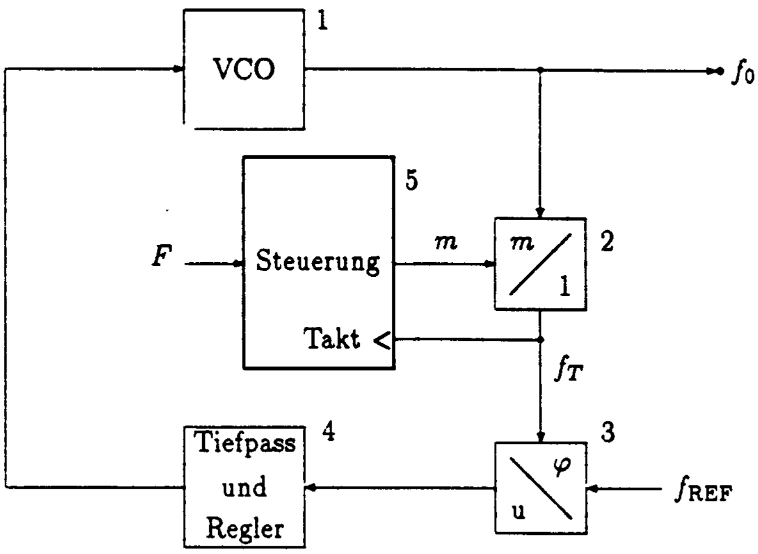


Fig. 1

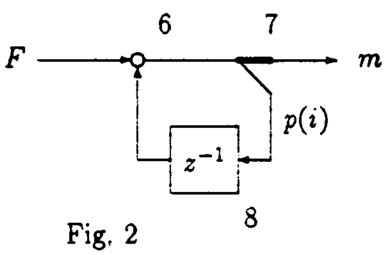


Fig. 2

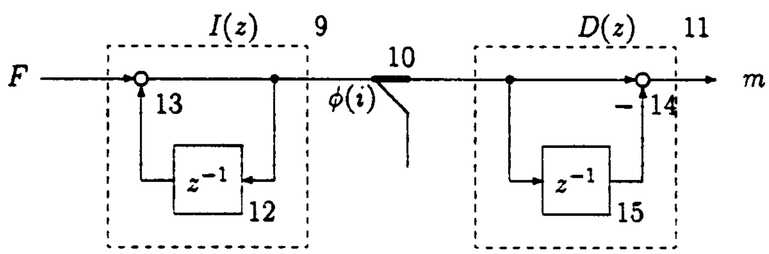


Fig. 4

| $F = 9,1$ | | |
|---|---|---|
| frakt.-Phase $p(i)$ | Summe $p(i-1)+F$ | Teilerwert $m(i)$ |
| 0.10 | 9.10 | 9 |
| 0.20 | 9.20 | 9 |
| 0.30 | 9.30 | 9 |
| 0.40 | 9.40 | 9 |
| 0.50 | 9.50 | 9 |
| 0.60 | 9.60 | 9 |
| 0.70 | 9.70 | 9 |
| 0.80 | 9.80 | 9 |
| 0.90 | 9.90 | 9 |
| 0.00 | 10.00 | 10 |
| 0.10 | 9.10 | 9 |
| 0.20 | 9.20 | 9 |
| 0.30 | 9.30 | 9 |
| 0.40 | 9.40 | 9 |
| 0.50 | 9.50 | 9 |
| 0.60 | 9.60 | 9 |
| 0.70 | 9.70 | 9 |
| 0.80 | 9.80 | 9 |
| 0.90 | 9.90 | 9 |
| 0.00 | 10.00 | 10 |
| 0.10 | 9.10 | 9 |
| 0.20 | 9.20 | 9 |

Fig. 3

| $F = 9,1$ | | |
|---|---|---|
| Phase $\phi(i)$ | Quantisierung $q(i)$ | Teilerwert $m(i)$ |
| 9.10 | 9 | 9 |
| 18.20 | 18 | 9 |
| 27.30 | 27 | 9 |
| 36.40 | 36 | 9 |
| 45.50 | 45 | 9 |
| 54.60 | 54 | 9 |
| 63.70 | 63 | 9 |
| 72.80 | 72 | 9 |
| 81.90 | 81 | 9 |
| 91.00 | 91 | 10 |
| 100.10 | 100 | 9 |
| 109.20 | 109 | 9 |
| 118.30 | 118 | 9 |
| 127.40 | 127 | 9 |
| 136.50 | 136 | 9 |
| 145.60 | 145 | 9 |
| 154.70 | 154 | 9 |
| 163.80 | 163 | 9 |
| 172.90 | 172 | 9 |
| 182.00 | 182 | 10 |
| 191.10 | 191 | 9 |
| 200.20 | 200 | 9 |

Fig. 5

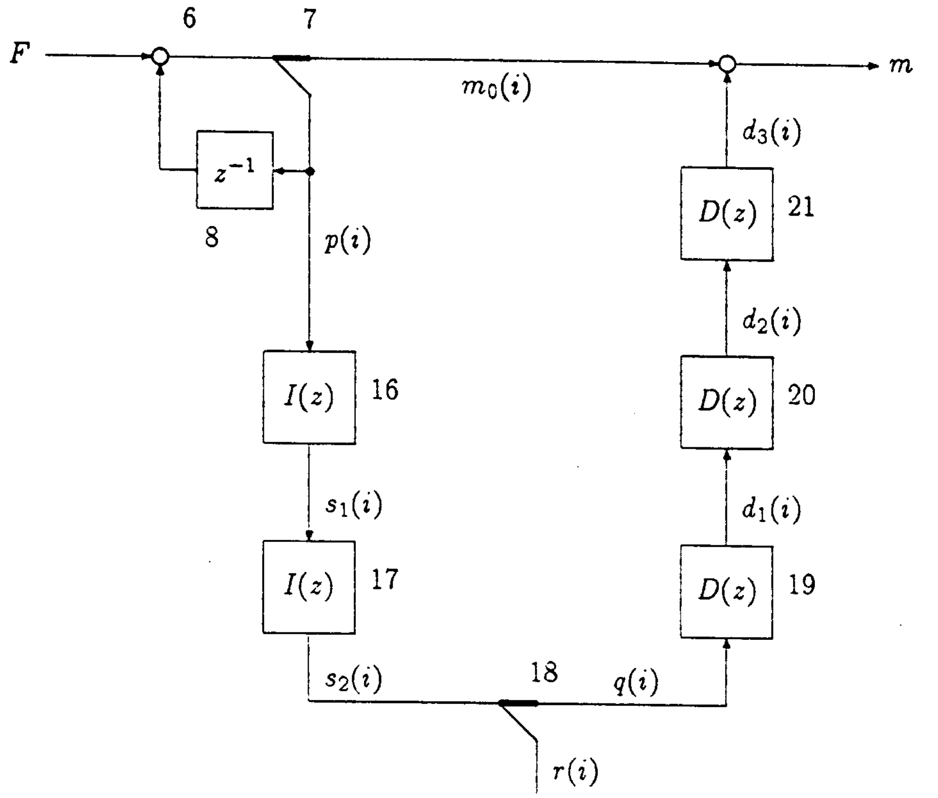


Fig. 6

| $F = 9{,}1$ | | | | | | | | | |
|---|---|---|---|---|---|---|---|---|---|
| frakt. Phase $p(i)$ | Integral der frakt. Phase $s_1(i)$ | Integral-Integral der frakt. Phase $s_2(i)$ | ganzer Teil $q(i)$ | $d_1(i)$ | $d_2(i)$ | $d_3(i)$ | Frequenz-Anteil $m_0(i)$ | Teiler-wert $m(i)$ | Phasen-fehler |
| 0.10 | 0.10 | 0.10 | 0 | 0 | 0 | 0 | 9 | 9 | 0.10 |
| 0.20 | 0.30 | 0.40 | 0 | 0 | 0 | 0 | 9 | 9 | 0.20 |
| 0.30 | 0.60 | 1.00 | 1 | 1 | 1 | 1 | 9 | 10 | -0.70 |
| 0.40 | 1.00 | 2.00 | 2 | 1 | 0 | -1 | 9 | 8 | 0.40 |
| 0.50 | 1.50 | 3.50 | 3 | 1 | 0 | 0 | 9 | 9 | 0.50 |
| 0.60 | 2.10 | 5.60 | 5 | 2 | 1 | 1 | 9 | 10 | -0.40 |
| 0.70 | 2.80 | 8.40 | 8 | 3 | 1 | 0 | 9 | 9 | -0.30 |
| 0.80 | 3.60 | 12.00 | 12 | 4 | 1 | 0 | 9 | 9 | -0.20 |
| 0.90 | 4.50 | 16.50 | 16 | 4 | 0 | -1 | 9 | 8 | 0.90 |
| 0.00 | 4.50 | 21.00 | 21 | 5 | 1 | 1 | 10 | 11 | -1.00 |
| 0.10 | 4.60 | 25.60 | 25 | 4 | -1 | -2 | 9 | 7 | 1.10 |
| 0.20 | 4.80 | 30.40 | 30 | 5 | 1 | 2 | 9 | 11 | -0.80 |
| 0.30 | 5.10 | 35.50 | 35 | 5 | 0 | -1 | 9 | 8 | 0.30 |
| 0.40 | 5.50 | 41.00 | 41 | 6 | 1 | 1 | 9 | 10 | -0.60 |
| 0.50 | 6.00 | 47.00 | 47 | 6 | 0 | -1 | 9 | 8 | 0.50 |
| 0.60 | 6.60 | 53.60 | 53 | 6 | 0 | 0 | 9 | 9 | 0.60 |
| 0.70 | 7.30 | 60.90 | 60 | 7 | 1 | 1 | 9 | 10 | -0.30 |
| 0.80 | 8.10 | 69.00 | 69 | 9 | 2 | 1 | 9 | 10 | -1.20 |
| 0.90 | 9.00 | 78.00 | 78 | 9 | 0 | -2 | 9 | 7 | 0.90 |
| 0.00 | 9.00 | 87.00 | 87 | 9 | 0 | 0 | 10 | 10 | 0.00 |
| 0.10 | 9.10 | 96.10 | 96 | 9 | 0 | 0 | 9 | 9 | 0.10 |
| 0.20 | 9.30 | 105.40 | 105 | 9 | 0 | 0 | 9 | 9 | 0.20 |
| 0.30 | 9.60 | 115.00 | 115 | 10 | 1 | 1 | 9 | 10 | -0.70 |

Fig. 7

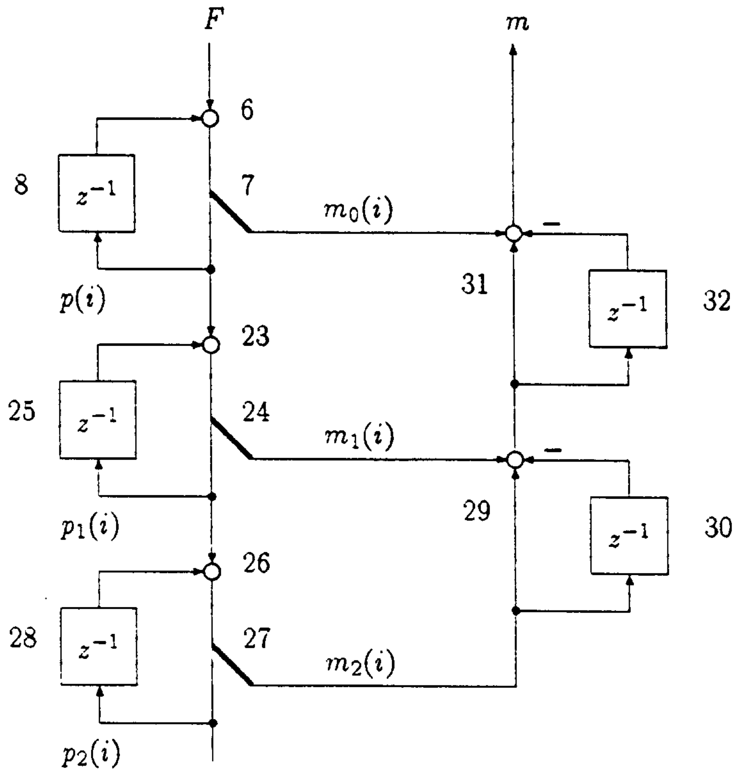


Fig. 8

| $F = 9,1$ | | | | | | | |
|---|---|---|---|---|---|---|---|
| frakt. Phase $p(i)$ | frakt. Integral der frakt. Phase $p_1(i)$ | frakt. Integral-Integral der frakt. Phase $p_2(i)$ | Frequenz-anteil $m_0(i)$ | $m_1(i)$ | $m_2(i)$ | Teiler-wert $m(i)$ | Phasen-fehler |
| 0.10 | 0.10 | 0.10 | 9 | 0 | 0 | 9 | 0.10 |
| 0.20 | 0.30 | 0.40 | 9 | 0 | 0 | 9 | 0.20 |
| 0.30 | 0.60 | 0.00 | 9 | 0 | 1 | 10 | -0.70 |
| 0.40 | 0.00 | 0.00 | 9 | 1 | 0 | 8 | 0.40 |
| 0.50 | 0.50 | 0.50 | 9 | 0 | 0 | 9 | 0.50 |
| 0.60 | 0.10 | 0.60 | 9 | 1 | 0 | 10 | -0.40 |
| 0.70 | 0.80 | 0.40 | 9 | 0 | 1 | 9 | -0.30 |
| 0.80 | 0.60 | 0.00 | 9 | 1 | 1 | 9 | -0.20 |
| 0.90 | 0.50 | 0.50 | 9 | 1 | 0 | 8 | 0.90 |
| 0.00 | 0.50 | 0.00 | 10 | 0 | 1 | 11 | -1.00 |
| 0.10 | 0.60 | 0.60 | 9 | 0 | 0 | 7 | 1.10 |
| 0.20 | 0.80 | 0.40 | 9 | 0 | 1 | 11 | -0.80 |
| 0.30 | 0.10 | 0.50 | 9 | 1 | 0 | 8 | 0.30 |
| 0.40 | 0.50 | 0.00 | 9 | 0 | 1 | 10 | -0.60 |
| 0.50 | 0.00 | 0.00 | 9 | 1 | 0 | 8 | 0.50 |
| 0.60 | 0.60 | 0.60 | 9 | 0 | 0 | 9 | 0.60 |
| 0.70 | 0.30 | 0.90 | 9 | 1 | 0 | 10 | -0.30 |
| 0.80 | 0.10 | 0.00 | 9 | 1 | 1 | 10 | -1.20 |
| 0.90 | 0.00 | 0.00 | 9 | 1 | 0 | 7 | 0.90 |
| 0.00 | 0.00 | 0.00 | 10 | 0 | 0 | 10 | 0.00 |
| 0.10 | 0.10 | 0.10 | 9 | 0 | 0 | 9 | 0.10 |
| 0.20 | 0.30 | 0.40 | 9 | 0 | 0 | 9 | 0.20 |
| 0.30 | 0.60 | 0.00 | 9 | 0 | 1 | 10 | -0.70 |

Fig. 9